# EUROPEAN PATENT APPLICATION

(11) **EP 2 624 270 A2**
(43) Date of publication of application: **07.08.2013**
(21) Application number: 12165402.4
(22) Date of filing: 24.04.2012
(51) Int. Cl.: H01G 9/20

(54) **Photoelectric device**

(30) Priority: 31.01.2012 US 201261592721 P
(71) Applicant: Samsung SDI Co., Ltd., Yongin-si, Gyeonggi-do (KR)
(72) Inventor: Kim, Hyun-Chul, Gyeonggi-do (KR); Eom, Sang-Hyun, Gyeonggi-do (KR)
(74) Representative: Walaski, Jan Filip

(57) **Abstract**

A photoelectric device includes a first substrate on which first finger electrodes are formed and a light absorption layer is formed between neighbouring first finger electrodes and a second substrate facing the first substrate, on which second finger electrodes are formed to face the light absorption layer, thereby having improved photoelectric conversion efficiency.

## Description

The present invention relates to a photoelectric device.

Extensive research has recently been conducted on photoelectric devices that convert light into electric energy. From among such devices, solar cells utilizing sunlight have attracted attention as alternative energy sources to fossil fuels.

Research on solar cells having various working principles has been continuously conducted. From among such solar cells, dye-sensitized solar cells have remarkably high photoelectric conversion efficiency compared with typical solar cells and thus are attracting attention as next generation solar cells.

Dye-sensitized solar cells include a photosensitive dye that receives visible light and generates excited electrons, a semiconductor material that receives the excited electrons, and an electrolyte that reacts with electrons returning from an external circuit.

One or more embodiments of the present invention include a photoelectric device having increased photoelectric conversion efficiency.

According to an aspect of the invention, there is provided a photoelectric device comprising a first substrate on which a plurality of first finger electrodes are formed, a second substrate on which a plurality of second finger electrodes are formed and light absorption layers between neighbouring ones of the first finger electrodes, wherein the second finger electrodes are aligned with the light absorption layers.

The first and second finger electrodes may be asymmetrically arranged so as not to face each other. The second finger electrodes may be arranged with a narrower pitch than the first finger electrodes.

The second finger electrodes may be arranged in groups, each group corresponding to a respective one of the light absorption layers, the spacing between the groups being greater than the pitch of the second finger electrodes.

The photoelectric device may comprise a catalyst layer formed over the second finger electrodes.

The pitch of the second finger electrodes may be arranged such that the catalyst layer between adjacent ones of the second finger electrodes has a concave profile.

The height of the catalyst layer between adjacent ones of the second finger electrodes may be greater than the height of the catalyst layer between the groups of the second finger electrodes.

The photoelectric device may comprise protective layers on the second finger electrodes, wherein the catalyst layer is disposed on the protective layers.

The height of the catalyst layer between adjacent ones of the second finger electrodes may be greater than the thickness of the catalyst layer over each of the protective layers.

A first conductive layer and a second conductive layer may be disposed between the first substrate and the first finger electrodes, and between the second substrate and the second finger electrodes, respectively.

The catalyst layer may be in contact with the second conductive layer.

The photoelectric device may further comprise a first collector electrode connected to the first finger electrodes, the first collector electrode and the first finger electrodes together forming a first comb electrode and a second collector electrode connected to the second finger electrodes, the second collector electrode and the second finger electrodes together forming a second comb electrode.

The photoelectric device may further comprise an electrolyte between the first and second substrates.

According to the one or more of the above embodiments of the present invention, first finger electrodes formed on a light receiving surface and second finger electrodes formed on an opposite surface are differently designed such that light absorption layers and the second finger electrodes face each other and thus a photoelectric device has improved photoelectric conversion efficiency.

In addition, the first finger electrodes and the second finger electrodes are differently designed such that an aperture ratio with respect to incident light is increased so as to reduce a resistance loss of a light current path and to increase a deposition height of a catalyst layer while reducing an optical loss.

Embodiments of the invention will now be described by way of example with reference to the accompanying drawings, in which:
FIG. 1 is an exploded perspective view of a photoelectric device according to an embodiment of the present invention;
FIG. 2 is a cross-sectional view of the photoelectric device taken along II-II of FIG. 1, according to an embodiment of the present invention;
FIG. 3 is a cross-sectional view of a photoelectric device according to a comparative example for comparison with embodiments of the present invention;
FIGS. 4 to 6 are cross-sectional views of photoelectric devices according to Examples 1 to 3; and
FIGS. 7A to 7C shows simulation results in which resistance distribution of a second conductive layer varies as the number of second finger electrodes varies.

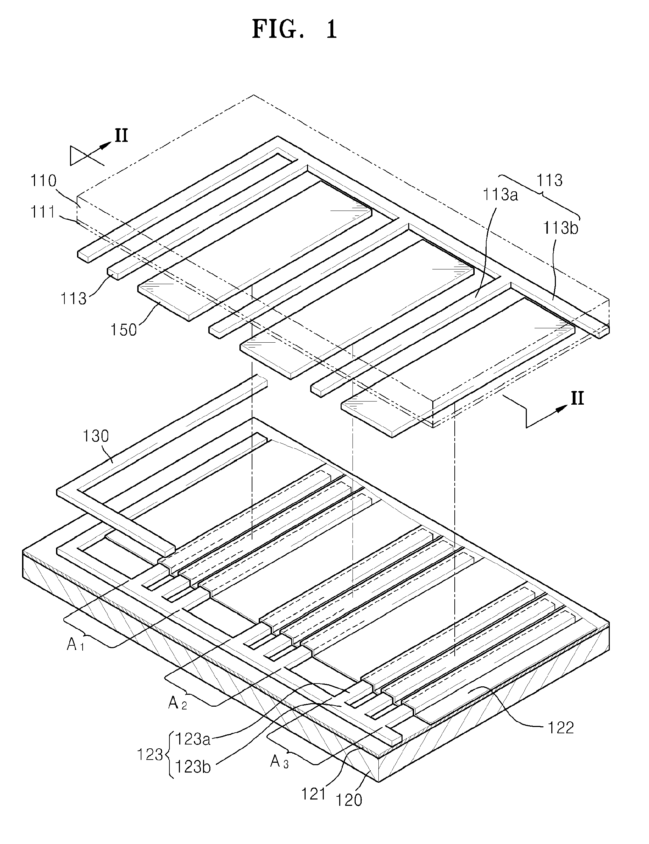

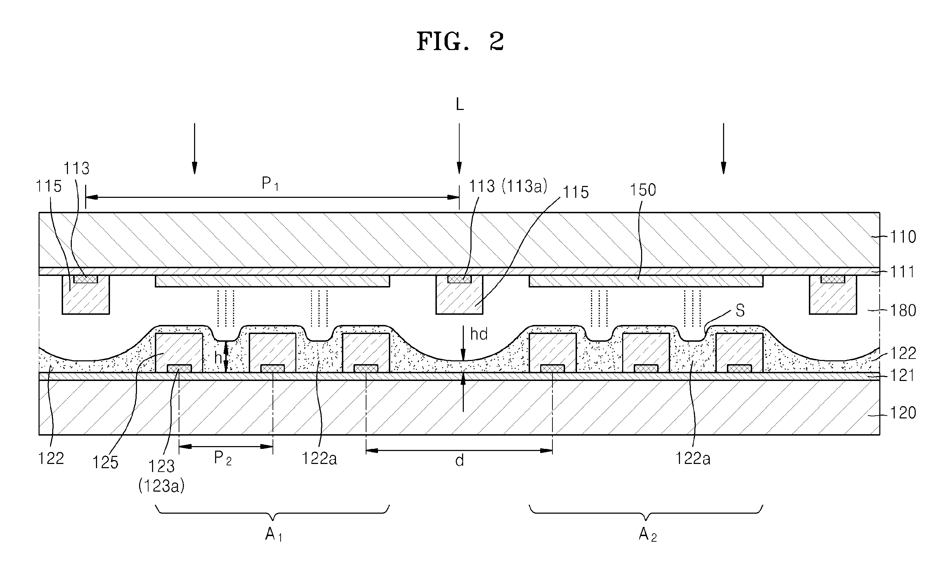

Referring to FIGS. 1 and 2, a first substrate 110 on which a first comb electrode 113 is formed and a second substrate 120 on which a second comb electrode 123 is formed are disposed to face each other, wherein a sealing member 130 is interposed between the first substrate 110 and the second substrate 120. Light absorption layers 150 and a catalyst layer 122 are formed adjacent to the first and second comb electrodes 113 and 123, respectively. The first comb electrode 113 comprises a first collector electrode 113b from which a plurality of first finger electrodes 113a extend. Similarly, the second comb electrode 123 comprises a second collector electrode 123b from which a plurality of second finger electrodes 123a extend. In this embodiment, the first finger electrodes 113a are arranged parallel to one another and extend perpendicular to the first collector electrode 113b, also referred to as being arranged in a stripe pattern. Similarly, the second finger electrodes 123a are arranged parallel to one another and extend perpendicular to the second collector electrode 123b.

The first and second collector electrodes 113b, 123b may serve as electrical contact points with an external circuit (not shown) or may be electrically connected to another photoelectric device (not shown) so as to constitute a modular structure.

The light absorption layers 150 may be patterned between neighbouring first finger electrodes 113a on the first substrate 110. The catalyst layer 122 may be formed on the second substrate 120 so as to cover the second finger electrodes 123a. However, positions where the light absorption layers 150 and the catalyst layer 122 are formed are not limited to the positions shown in FIGS. 1 and 2.

For example, the first substrate 110 may serve as a light receiving surface and the first comb electrode 113 formed on the first substrate 110 may serve as a negative electrode from which light generating carriers (electrons) are extracted. The second substrate 120 may be disposed opposite to the light receiving surface and the second comb electrode 123 formed on the second substrate 120 may serve as a positive electrode for accepting a current passing through an external circuit (not shown). That is, the first and second comb electrodes 113 and 123 may respectively serve as negative and positive electrodes for the flow of photoelectric current.

First and second conductive layers 111 and 121 may be respectively formed on the first and second substrates 110 and 120. The first and second conductive layers 111 and 121 together with the first and second substrates 110 and 120 may constitute a conductive substrate. The first and second comb electrodes 113 and 123 may be respectively formed on the first and second conductive layers 111 and 121 and may reinforce conductivity of the first and second conductive layers 111 and 121 so as to reduce electric resistance.

The first and second finger electrodes 113a, 123a are asymmetrically formed. That is, the first and second finger electrodes 113a, 123a may be formed to be out of line so as not to face each other. In detail, each of the light absorption layers 150 may be disposed between neighbouring first finger electrodes 113a. The second finger electrodes 123a may be disposed to respectively face the light absorption layers 150, that is, may be respectively disposed below the light absorption layers 150, also described as being aligned with the light absorption layers. For example, the second finger electrodes 123a may be densely arranged below the light absorption layers 150 and may include different groups A1, A2, and A3 that are densely arranged below the light absorption layers 150, respectively.

The light absorption layers 150 and the second finger electrodes 123a may be stacked on each other so as to overlap each other, thereby reinforcing an electrical field between the light absorption layers 150 and the second finger electrodes 123a to facilitate transfer of electrons to the light absorption layers 150, which will now be described in more detail.

That is, the light absorption layers 150 may absorb incident light L and may generate light generating carriers (electrons). The light absorption layers 150 that are oxidized by extracting the light generating carriers may be reduced again through the catalyst layer 122 that provides electrons by using an electrolyte 180 as a medium. In this case, since the catalyst layer 122 accepts through the second conductive layer 121 a flow of electrons passing through the second finger electrodes 123a, catalyst layer portions 122a of the catalyst layer 122, which are adjacent to the second finger electrodes 123a and contact directly the second conductive layer 121, for example, the catalyst layer portions 122a between neighbouring second finger electrodes 123a or the catalyst layer portions 122a adjacent to the second finger electrodes 123a may contribute greatly to reduction of the light absorption layers 150. Thus, the second finger electrodes 123a and the light absorption layers 150 are formed to face each other such that the catalyst layer portions 122a adjacent to the second finger electrodes 123a may closely and approximately face the light absorption layers 150, thereby reinforcing an electrical field to facilitate transfer of electrons to the light absorption layers 150.

In addition, the light absorption layers 150 and the second finger electrodes 123a may be stacked on each other so as to overlap each other and a gap between the light absorption layers 150 and the second finger electrodes 123a is reduced, thereby increasing ion mobility. For example, the light absorption layers 150 and the catalyst layer portions 122a adjacent to the second finger electrodes 123a may closely and approximately face each other, thereby reducing a path for transferring electrons.

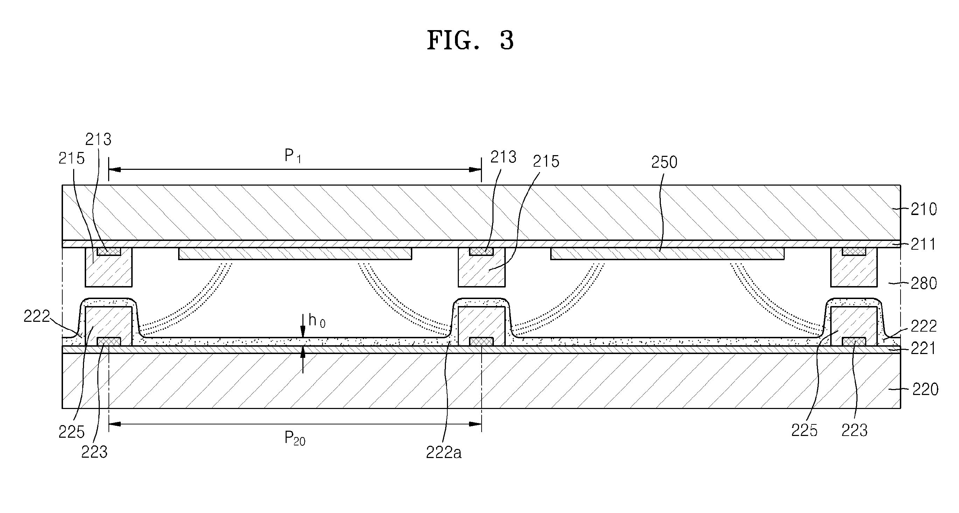

FIG. 3 is a cross-sectional view of a photoelectric device according to a comparative example for comparison with embodiments of the present invention. Referring to FIG. 3, a first substrate 210 on which first finger electrodes 213 are formed and a second substrate 220 on which second finger electrodes 223 are formed are disposed to face each other. First and second conductive layers 211 and 221 are formed on the first and second substrates 210 and 220, respectively.

The first and second finger electrodes 213 and 223 may be symmetrically formed to face each other. A light absorption layer 250 is formed between neighbouring first finger electrodes 213 and the second finger electrodes 223 may be disposed to face the first finger electrodes 213, respectively. According to the comparative example, a gap between the light absorption layers 250 and the second finger electrodes 223 is increased and an electrical field formed through an electrolyte 280 is weakened, thereby reducing ion mobility. That is, since a gap between the light absorption layers 250 and catalyst layer portions 222a adjacent to the second finger electrodes 223 is increased, resistance of an optical current path is increased, thereby reducing a fillfactor and photoelectric conversion efficiency.

As an electrode pitch P20 between the second finger electrodes 223 is increased, a deposition height ho of a portion of a catalyst layer 222, which is formed between the second finger electrodes 223, is reduced. When the deposition height ho of the catalyst layer 222 is reduced, the catalyst layer 222 with low density is formed on the same area, thereby reducing electrolyte reduction efficiency of the catalyst layer 222. In FIG. 3, reference numerals 215 and 225 indicate protective layers for covering the first and second finger electrodes 213 and 223, respectively.

On the other hand, referring to FIG. 2, the first and second finger electrodes 113a, 123a may be disposed at first and second electrode pitches P1 and P2 that are different from each other. Not all of the first finger electrodes 113a or the second finger electrodes 123a may be evenly spaced apart from each other. In this case, the first and second electrode pitches P1 and P2 of the first and second finger electrodes 113a, 123a may respectively refer to the regular spacing between the closest ones of the first and second finger electrodes 113a, 123a. For example, when the second finger electrodes 123a are densely disposed below the light absorption layers 150, the second electrode pitch P2 refers to the spacing/interval between the closest ones of the finger electrodes 123a and not to the spacing between the groups of electrodes A1, A2, A3 which can also be referred to as the group pitch.

The first finger electrodes 113a may be spaced apart from each other at the first electrode pitch P1. The light absorption layers 150 may each be interposed between neighbouring first finger electrodes 113a and may be arranged at the first electrode pitch P1 that is relatively wide so as to receive as much as possible the amount of the incident light L.

With regard to the arrangement of the second finger electrodes 123a, the second finger electrodes 123a of a first group A1 are disposed below one of the light absorption layers 150 and the second finger electrodes 123a of a second group A2 are disposed below another one of the light absorption layers 150. In this case, the second finger electrodes 123a of the first group A1 may be densely arranged at the second electrode pitch P2. Similarly, the second finger electrodes 123a of the second group A2 may be densely arranged at the second electrode pitch P2. In addition, the second finger electrodes 123a of the first group A1 and the second finger electrodes 123a of the second group A2 may be spaced apart from each other at an interval 'd' that is greater than the second electrode pitch P2. An interval 'd' between neighbouring second finger electrodes 123a from among the second finger electrodes 123a of the first group A1 and the second group A2 may be greater than the second electrode pitch P2.

The first and second finger electrodes 113a and 123a may be formed on different sides, that is, on the first and second substrates 110 and 120, respectively. The first finger electrodes 113a of the light receiving surface may have a higher aperture ratio than the second finger electrodes 123a of an opposite surface so that the light absorption layers 150 can receive as much as possible of the amount of the incident light L.

An aperture ratio refers to a relative ratio of portions of a substrate, which are exposed between the first and second finger electrodes 113a, 123a, that is, the substrate except for portions that are occupied by the first and second finger electrodes 113a, 123a to an entire substrate. The first and second finger electrodes 113a, 123a may be formed of an opaque metal material and thus the aperture ratio may refer to a ratio of an effective incident area for receiving incident light.

The first finger electrodes 113a of the light receiving surface may be designed to have a higher aperture ratio than the second finger electrodes 123a of an opposite surface. A large amount of the incident light L may be received by the light absorption layers 150, thereby increasing efficiency of the photoelectric device. In more detail, in this embodiment, the first electrode pitch P1 is greater than the second electrode pitch P2 (P1 > P2).

The second finger electrodes 123a are formed on the opposite surface and thus there is not much need to consider an aperture ratio. Thus, the second electrode pitch P2 is small, that is, the second finger electrodes 123a are densely arranged, thereby providing a current path with low resistance and preventing a reduction in efficiency due to a resistance loss.

The second finger electrodes 123a may receive a flow of current passing through an external circuit (not shown) and may respectively distribute reduction electrons to sections of the photoelectric device. The catalyst layer 122 may be formed between the second finger electrodes 123a. That is, the catalyst layer portions 122a adjacent the second finger electrodes 123a may be accommodated between neighbouring second finger electrodes 123a and may be accommodated in a recess between the second electrodes, which corresponds to the second electrode pitch P2.

The catalyst layer 122 may be formed across the second substrate 120. However, since the catalyst layer portions 122a adjacent to the second finger electrodes 123a, that is, the catalyst layer portions 122a between the second finger electrodes 123a may contribute greatly to photoelectric transformation, a deposition height h of the catalyst layer 122 between the second finger electrodes 123a is important. That is, the deposition height h of the catalyst layer 122 indicates density of the catalyst layer 122. In addition, as the deposition height h is increased, the catalyst layer 122 with higher density is formed on the same area.

The second finger electrodes 123a may increase the deposition height h of the catalyst layer 122. As shown in FIGS. 1 and 2, a free surface S of the catalyst layer 122 may have a curved shape. The catalyst layer 122 may be closely attached to two walls of each of the second finger electrodes 123a, that is, two walls of each of protective layer 125 and may have recesses having a concave shape. In other words, the catalyst layer 122 may has a highest deposition height at a portion where the catalyst layer 122 is closely attached to the walls of each of the second finger electrodes 123a and may have recesses having a concave shape such that the deposition height h is reduced away from the second finger electrodes 123a.

The protective layers 125 of the second finger electrodes 123a may provide attachment surfaces to which the catalyst layer 122 is attached. Thus, the deposition height h of the catalyst layer 122 may be increased and the catalyst layer 122 with high density may be formed on the same area. When the second electrode pitch P2 is low, electrical conductivity may be increased and a resistance loss may be reduced while the catalyst layer 122 with high density may be formed.

When the second finger electrodes 123a of the first group A1 below the light absorption layer 150 and the second finger electrodes 123a of the second group A2 below another light absorption layer 150 are arranged, a deposition height h of the catalyst layer 122 between the second finger electrodes 123a of the first group A1 may be greater than a deposition height hd of the catalyst layer 122 between the second finger electrodes 123a of the first group A1 and the second group A2 that are adjacent to each other. The second finger electrodes 123a that are densely arranged below the light absorption layers 150, in more detail, the protective layers 125 of the second finger electrodes 123a may provide the attachment surfaces to which the catalyst layer 122 is attached.

Hereinafter, components of the photoelectric device will be described in more detail with reference to FIGS. 1 and 2.

The first and second substrates 110 and 120 may be formed of a transparent material and may be formed of a material having high light transmittance. For example, the first and second substrates 110 and 120 may be a glass substrate or a resin film. Since the resin film is flexible, the resin film is suitable for use that requires flexibility.

The first and second conductive layers 111 and 121 that are respectively formed on the first and second substrates 110 and 120 may be formed of a transparent conductive material having electrical conductivity and optical transparency, such as a transparent conductive oxide (TCO), for example, indium tin oxide (ITO), fluorine-doped tin oxide (FTO), antimony tin oxide (ATO), or the like.

The first and second comb electrodes 113 and 123 that are respectively formed on the first and second substrates 110 and 120 may be formed of an opaque metal material having high electrical conductivity, for example, aluminium (Al), silver (Ag), or the like. The first and second comb electrodes 113 and 123 may be covered by protective layers 115 and 125, respectively. The protective layers 115 and 125 may prevent electrodes from corroding due to reaction with the electrolyte 180.

The light absorption layers 150 formed between the first finger electrodes 113a may include a semiconductor layer and a photosensitive dye adsorbed onto the semiconductor layer. For example, the semiconductor layer may be formed of a metal oxide such as cadmium (Cd), zinc (Zn), indium (In), lead (Pb), molybdenum (Mo), tungsten (W), antimony (Sb), titanium (Ti), silver (Ag), manganese (Mn), tin (Sn), zirconium (Zr), strontium (Sr), gallium (Ga), silicon (Si), chromium (Cr), or the like. For example, the photosensitive dye adsorbed onto the semiconductor layer may include molecules that absorbs light in a visible band and causes electrons to rapidly move from a light excitation state to the semiconductor layer. For example, the photosensitive dye may be ruthenium-based photosensitive dye.

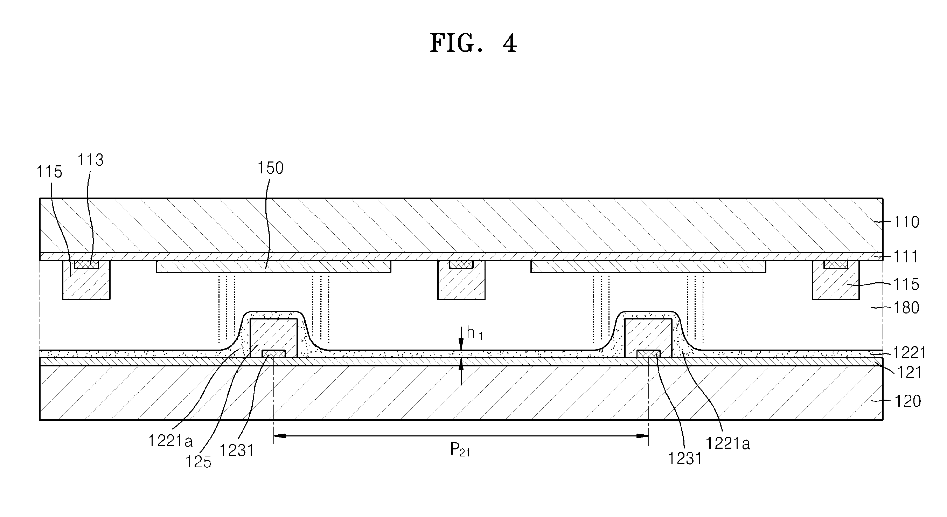

The catalyst layer 122 that fills between the second finger electrodes 123a and covers the second finger electrodes 123a may be formed of a material that serves as a reduction catalyst function for providing electrons to the electrolyte 180 and may be formed of, for example, metal such as platinum (Pt), gold (Au), silver (Ag), copper (Cu), or aluminium (Al), a metal oxide such as zinc oxide, or a carbon-based material such as graphite. The electrolyte 180 between the light absorption layers 150 and the catalyst layer 122 may be Redox electrolyte including a pair of oxidant and reductant. Table 1 below shows an open circuit voltage Voc and a short circuit current Isc, a fillfactor (FF) calculated based thereon, and photoelectric conversion efficiency (Eff) with respect to different Examples 1 to 3. In addition, FIGS. 4 to 6 show structures according to Examples 1 to 3.

**Table 1**

| | Voc(V) | Isc(A) | FF | Eff (%) |
|---|---|---|---|---|
| Example 1 | 0.67 | 1.37 | 0.61 | 5.6 |
| Example 2 | 0.67 | 1.35 | 0.63 | 5.7 |
| Example 3 | 0.66 | 1.38 | 0.69 | 6.2 |

Referring to FIGS. 4 to 6, Examples 1 to 3 have a common technological feature in that first and second finger electrodes 113a, 1231,1232, 1233 are asymmetrically formed and may be formed out of line so as not to face each other. In more detail, the light absorption layers 150 are disposed between neighbouring first finger electrodes 113a, and second finger electrodes 1231, 1232, 1233 are disposed to face the light absorption layers 150.

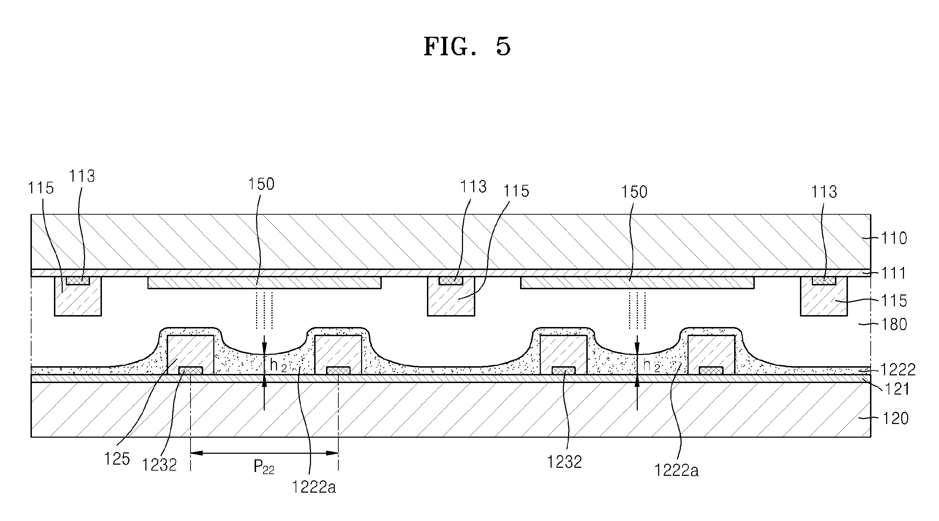

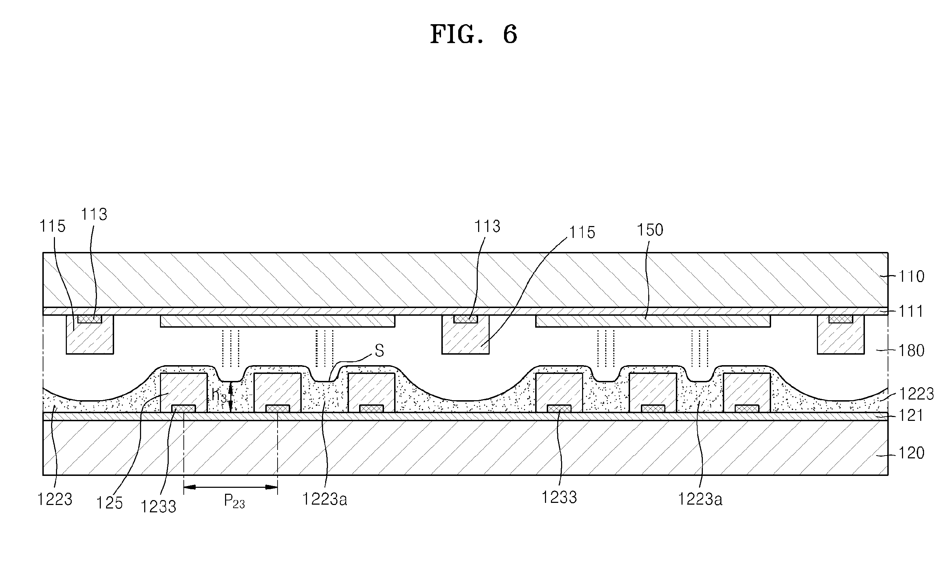

Examples 1 to 3 are different from each other in that different numbers of the second finger electrodes 1231, 1232, 1233 are disposed to correspond to the light absorption layers 150. That is, in Example 1 of FIG. 4, a single finger electrode 1231 is disposed to correspond to each of the light absorption layers 150. In Example 2 of FIG. 5, two second finger electrodes 1232 are disposed to correspond to each of the light absorption layers 150. In addition, in Example 3 of FIG. 6, three second finger electrodes 1233 are disposed to correspond to each of the light absorption layers 150.

For example, with regard to a photoelectric device that is designed such that the light absorption layers 150 have the same shape and the same size, that is, 20cm x 5cm, second electrode pitches P21, P22, P23 may be different from each other by differentiating the number of the second finger electrodes 1231, 1232, 1233 that are disposed for respective light absorption layers 150.

Based on the measurement results of a fillfactor (FF) and photoelectric conversion efficiency (Eff) of Table 1, it is confirmed that output characteristics in Example 2 are excellent compared with Example 1 and that output characteristics in Example 3 are excellent compared with Example 2. In more detail, based on the measurement of a fillfactor (FF), it is confirmed that a fillfactor (FF) in Example 2 is increased by about 3.3% compared with Example 1 and that a fillfactor (FF) in Example 3 is increased by about 9.5% compared with Example 2.

In other words, it is confirmed that the second finger electrodes 1231, 1232, 1233 may be densely arranged, thereby improving the output characteristics of a photoelectric device. The output characteristics of the photoelectric device may vary according to the second electrode pitches P21, P22, P23 since a resistance loss of the second finger electrodes 1231, 1232, 1233 that constitute an optical current path is reduced as the second finger electrodes 1231, 1232, 1233 are more densely arranged. That is, as the number of each of the second finger electrodes 1231, 1232, 1233 formed on the second conductive layer 121 having the same area is increased, direct current (DC) resistance of the optical current path is reduced.

As the second finger electrodes 1231, 1232, 1233 are more densely arranged to face the light absorption layers 150, an electrical field between the light absorption layers 150 and catalyst layers 1221, 1222, 1223 may be further reinforced. For example, the catalyst layers 1221, 1222, 1223 receives through the second conductive layer 121 a flow of electrons passing through the second finger electrodes 1231, 1232, 1233 and supplies the received electrons to the light absorption layers 150. Thus, the catalyst layers 1221, 1222, 1223 are formed across the second substrate 120. However, catalyst layer portions 1221a, 1222a, 1223a, which are adjacent to the second finger electrodes 1231, 1232, 1233 and contact directly the second conductive layer 121, for example, the catalyst layer portions 1221a, 1222a, 1223a adjacent to the second finger electrodes 1231, 1232, 1233 or the catalyst layer portions 1221a, 1222a, 1223a between the second finger electrodes 1231, 1232, 1233 may contribute greatly to photoelectric transformation. In this case, the catalyst layer portions 1221a, 1222a, 1223a adjacent to the second finger electrodes 1231, 1232, 1233 may be formed in a plurality of sections or may be formed across a wide region by increasing the number of the second finger electrodes 1231, 1232, 1233.

Referring to FIGS. 4 to 6, it may be confirmed that as the second electrode pitches P21, P22, P23 are reduced, each of deposition heights h1, h2, h3 of the catalyst layers 1221, 1222, 1223 varies. The deposition heights h1, h2, h3 of the catalyst layers 1221, 1222, 1223 refer to densities with which the catalyst layers 1221, 1222, 1223 are formed. As the height of the catalyst layers 1221, 1222, 1223 is increased, the catalyst layers 1221, 1222, 1223 are formed with a higher density. For example, the catalyst layers 1221, 1222, 1223 are formed with a high density on the same area, thereby improving efficiency with respect to the same area.

The deposition heights h1, h2, and h3 of the catalyst layer portions 1221a, 1222a, 1223a adjacent to the second finger electrodes 1231, 1232, 1233 are important. That is, comparing the deposition heights h1, h2, and h3 of the catalyst layers 1221, 1222, 1223 between the second finger electrodes 1231, 1232, and 1233, it may be confirmed that the deposition height h2 in Example 2 is grater than the deposition height h1 in Example 1. In addition, the deposition height h3 in Example 3 is greater than the deposition height h2 in Example 2.

The deposition heights h1, h2, h3 of the catalyst layers 1221, 1222, 1223 adjacent to the second finger electrodes 1231, 1232, 1233 vary according to the second electrode pitches P21, P22, P23, respectively, since the second finger electrodes 1231, 1232, 1233, in more detail, the protective layers 125 of the second finger electrodes 1231, 1232, 1233 provide attachment surfaces to which the catalyst layers 1221, 1222, 1223 are attached, respectively. For example, in Example 2 of FIG. 5, the catalyst layer portion 1222a adjacent to the second finger electrodes 1232, that is, the catalyst layer portion 1222a between the second finger electrodes 1232 are closely attached to two walls of each of the second finger electrode 1232 such that the deposition height h2 may be relatively high. In Example 3 of FIG. 6, it may be confirmed that, as the second electrode pitch P23 is reduced, a free surface of the catalyst layer 1223, which is recessed, is further planarized such that the deposition height h3 is increased.

As a result, as the second finger electrodes 1231, 1232, 1233 are more densely arranged, a resistance loss of an optical current path is further reduced. In addition, as many as possible the number of each of the second finger electrodes 1231, 1232, 1233 are arranged to face the light absorption layers 150 so as to reinforce an electrical field between the light absorption layers 150 and the catalyst layers 1221, 1222, 1223, and the deposition heights h1, h2, h3 of the catalyst layers 1221, 1222, 1223 are increased. Accordingly, in this case, a fillfactor and photoelectric conversion efficiency are increased, as shown in Table 1.

For example, when the second electrode pitch P23 is further reduced compared to Example 3 of FIG. 6, a fillfactor and photoelectric conversion efficiency may be increased. However, when the second electrode pitch P23 is outside an appropriate range and is too narrow, that is, when the second finger electrodes 1233 are too densely arranged, an area occupied by portions of the catalyst layer 1223, which correspond to the second electrode pitch P23, is reduced and an area occupied by the protective layers 125 covering the second finger electrodes 1233 may be increased. That is, when the second finger electrodes 1233 are excessively densely arranged within a limited area, an area occupied by the catalyst layer 1223 may be adversely affected. In addition, due to a limitation of manufacturing processes, the number of the second finger electrodes 1233 may be appropriately determined. For example, two or three second finger electrodes 1233 may be arranged to correspond to the light absorption layers 150.

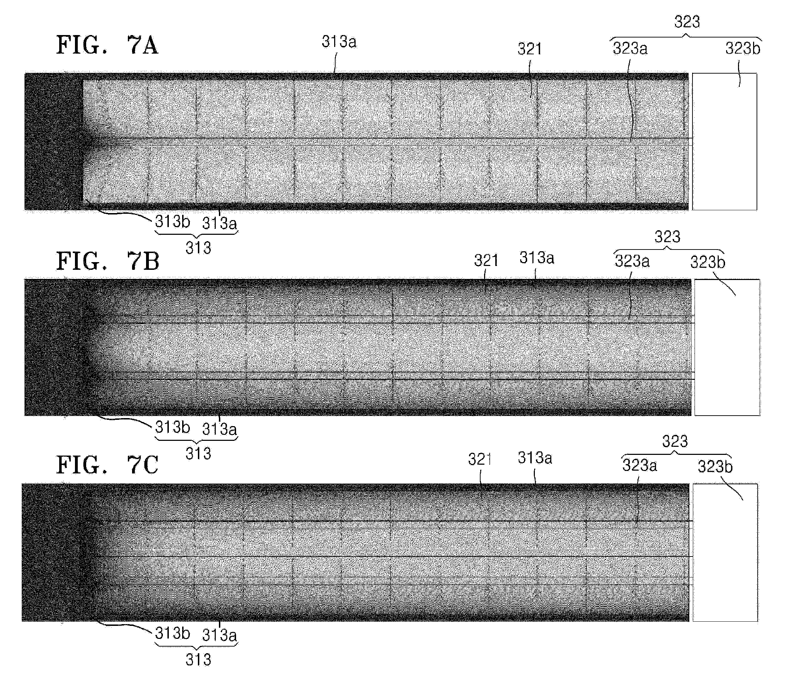

FIGS. 7A to 7C shows simulation results in which resistance distribution of a second conductive layer 321 varies as the number of second finger electrodes 323 varies.

The current simulation is modelled such that a first comb electrode 313 includes first finger electrodes 313a and a first collector electrode 313b and the second comb electrode 323 includes second finger electrodes 323a and a second collector electrode 323b.

FIGS. 7A to 7C have common features in that the second finger electrodes 323a are arranged between the first finger electrodes 313a. However, FIG. 7A shows a case of one second finger electrode 323a. FIG. 7B shows a case of two second finger electrodes 323a. In addition, FIG. 7C shows a case of three second finger electrodes 323a. FIGS. 7A to 7C show electrical resistance distributions of these three cases. As the number of the second finger electrodes 323a is increased, the entire brightness of the second conductive layer 321 gets darker. This means that electrical resistance on the second conductive layer 321 is reduced. With regard to a substrate having the same area, the number of the second finger electrodes 323a having electrical conductivity is increased, electrical resistance is reduced.

The simulation results of FIGS. 7A to 7C support the experimental results of Table 1. The simulation results shows that electrical resistance of an optical current path is reduced, which is one ground upon which, as the number of the second finger electrodes 323a is increased, the output characteristics of a photoelectric device are improved.

It should be understood that the exemplary embodiments described herein should be considered in a descriptive sense only and not for purposes of limitation. Descriptions of features or aspects within each embodiment should typically be considered as available for other similar features or aspects in other embodiments.

## Claims

1. A photoelectric device comprising:
a first substrate (110) on which a plurality of first finger electrodes (113a) are formed;
a second substrate (120) on which a plurality of second finger electrodes (123a) are formed; and
light absorption layers (150) between neighbouring ones of the first finger electrodes (113a);
wherein the second finger electrodes (123a, 1231, 1232, 1233) are aligned with the light absorption layers (150).

2. The photoelectric device of claim 1, wherein the first and second finger electrodes are asymmetrically arranged so as not to face each other.

3. The photoelectric device of claim 1 or 2, wherein the second finger electrodes are arranged with a narrower pitch than the first finger electrodes.

4. The photoelectric device of claim 3, wherein the second finger electrodes are arranged in groups, each group corresponding to a respective one of the light absorption layers (150), the spacing between the groups being greater than the pitch of the second finger electrodes.

5. The photoelectric device of any one of the preceding claims, comprising a catalyst layer (122, 1221, 1222, 1223) formed over the second finger electrodes.

6. The photoelectric device of claim 5, wherein the pitch of the second finger electrodes is arranged such that the catalyst layer between adjacent ones of the second finger electrodes has a concave profile.

7. The photoelectric device of claim 5 or 6, when dependent on claim 4, wherein the height of the catalyst layer between adjacent ones of the second finger electrodes is greater than the height of the catalyst layer between the groups of the second finger electrodes.

8. The photoelectric device of claim 5, 6 or 7, comprising protective layers (125) on the second finger electrodes, wherein the catalyst layer is disposed on the protective layers.

9. The photoelectric device of claim 8, wherein the height of the catalyst layer between adjacent ones of the second finger electrodes is greater than the thickness of the catalyst layer over each of the protective layers (125).

10. The photoelectric device of any one of the preceding claims, wherein a first conductive layer (111) and a second conductive layer (121) are disposed between the first substrate and the first finger electrodes, and between the second substrate and the second finger electrodes, respectively.

11. The photoelectric device of claim 10 when dependent on any one of claims 5 to 9, wherein the catalyst layer is in contact with the second conductive layer.

12. The photoelectric device of any one of the preceding claims, further comprising a first collector electrode (113b) connected to the first finger electrodes (113a), the first collector electrode and the first finger electrodes together forming a first comb electrode (113) and a second collector electrode (123b) connected to the second finger electrodes (123a), the second collector electrode and the second finger electrodes together forming a second comb electrode (123).

13. The photoelectric device of any one of the preceding claims, further comprising an electrolyte (180) between the first and second substrates.
